# EUROPEAN PATENT APPLICATION

(11) **EP 4 822 694 A1**
(43) Date of publication of application: **14.10.2026**
(21) Application number: 26171466.1
(22) Date of filing: 09.04.2026
(51) Int. Cl.: G11C 5/02

(54) **COMPUTE DIE CAPABLE OF TOLERATING FAILURE OF AT LEAST ONE HIGH BANDWIDTH MEMORY CHANNEL AND RELATED SEMICONDUCTOR PACKAGE**

(30) Priority: 11.04.2025 US 202563787261 P; 07.04.2026 US 202619641509
(71) Applicant: MediaTek Inc., Hsinchu City 30078 (TW)
(72) Inventor: KOLLURU, Krishna Bharath, San Jose, CA, 95134 (US); KUMAR, Arvind, San Jose, CA, 95134 (US); NALAMALPU, Ankireddy, San Jose, CA, 95134 (US); SUBBAREDDY, Dheeraj Reddy, San Jose, CA, 95134 (US); KUMASHIKAR, Mahesh K., San Jose, CA, 95134 (US); GADEY, Siva, San Jose, CA, 95134 (US)
(74) Representative: Pfenning, Meinig & Partner mbB

(57) **Abstract**

A compute die (200) includes a high bandwidth memory, HBM, interface subsystem (204). The HMB interface subsystem (204) includes an HBM controller circuit (206) and an HBM physical layer, PHY, circuit (208). The HBM controller circuit (206) is configured to control access of at least one HBM. The HBM PHY circuit (208) is configured to communicate with the at least one HBM. The HBM interface subsystem (204) is configured to tolerate failure of at least one HBM channel through channel redundancy.

## Description

### Field of the Invention

The present disclosure relates to an integrated circuit (IC) design, and more particularly, to a compute die capable of tolerating failure of at least one high bandwidth memory (HBM) channel and a related semiconductor package.

### Background of the Invention

HBM systems are commonly utilized in application-specific integrated circuit (ASIC) chip designs that utilize special purposes processors such as artificial intelligence (Al) accelerators, graphics processing units (GPUs), central processing units (CPUs), or other datacenter processors. The number of HBMs on an ASIC chip has scaled considerably. As a result, the area of an HBM controller circuit and an HBM physical layer (PHY) circuit has increased significantly on a compute die (e.g., an XPU die) included in the ASIC chip. If there is a fault or a yield issue on the HBM controller circuit and the HBM PHY circuit, the entire die complex has to be discarded after it has been assembled and packaged.

### Summary of the Invention

This in mind, the present invention aims at providing a compute die capable of tolerating failure of at least one HBM channel and a related semiconductor package.

This is achieved by a compute die and a semiconductor package according to the independent claims. The dependent claims pertain to corresponding further developments and improvements. The scope of the invention is defined by the appended sets of claims.

As will be seen more clearly from the detailed description following below, the claimed compute die includes a high bandwidth memory (HBM) interface subsystem. The HBM interface subsystem includes an HBM controller circuit and an HBM physical layer (PHY) circuit. The HBM controller circuit is configured to control access of at least one HBM. The HBM PHY circuit is configured to communicate with the at least one HBM. The HBM interface subsystem is configured to tolerate failure of at least one HBM channel through channel redundancy.

The claimed semiconductor package includes at least one high bandwidth memory (HBM) and a compute die. The compute die includes an HBM interface subsystem. The HBM interface subsystem includes an HBM controller circuit and an HBM physical layer (PHY) circuit. The HBM controller circuit is configured to control access of at least one HBM. The HBM PHY circuit is configured to communicate with the at least one HBM. The HBM interface subsystem is configured to tolerate failure of at least one HBM channel through channel redundancy.

### Brief Description of the Drawings

In the following, the invention is further illustrated by way of example, taking reference to the accompanying drawings. Thereof
FIG. 1 is a diagram illustrating a structure of a semiconductor package according to an embodiment of the present invention,
FIG. 2 is a block diagram of a compute die with HBM channel failure tolerance according to an embodiment of the present invention,
FIG. 3 is a diagram illustrating a first ASIC chip design according to an embodiment of the present invention, and
FIG. 4 is a diagram illustrating a second ASIC chip design according to an embodiment of the present invention.

### Detailed Description

Certain terms are used throughout the following description and claims, which refer to particular components. As one skilled in the art will appreciate, electronic equipment manufacturers may refer to a component by different names. This document does not intend to distinguish between components that differ in name but not in function. In the following description and in the claims, the terms "include" and "comprise" are used in an open-ended fashion, and thus should be interpreted to mean "include, but not limited to ...". Also, the term "couple" is intended to mean either an indirect or direct electrical connection. Accordingly, if one device is coupled to another device, that connection may be through a direct electrical connection, or through an indirect electrical connection via other devices and connections.

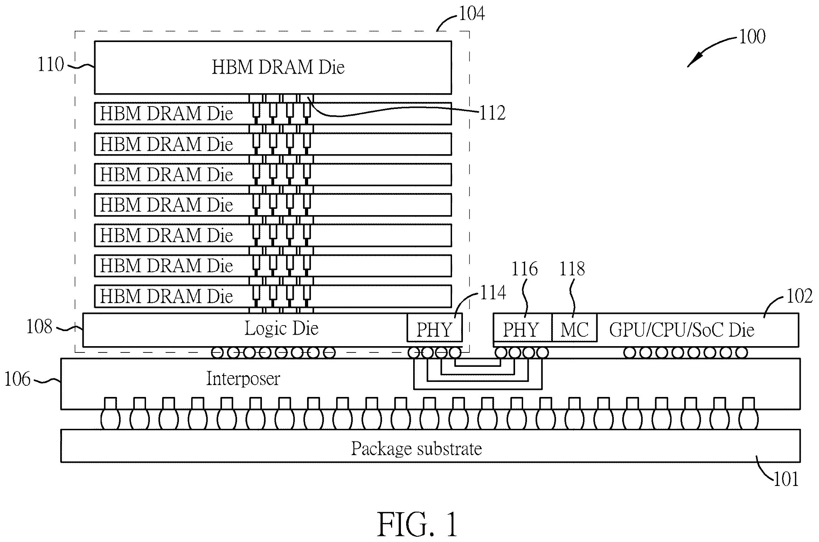

FIG. 1 is a diagram illustrating a structure of a semiconductor package according to an embodiment of the present invention. The semiconductor package 100 may be an ASIC chip. As shown in FIG. 1, the semiconductor package 100 includes a package substrate 101, a compute die 102, an HBM 104, and an interposer 106. Both of the compute die 102 and the HBM 104 are mounted on the interposer 105, and are connected through the interposer 105. In this embodiment, the compute die 102 and the HBM 104 are placed side-by-side on the interposer 105. The HBM 104 adopts a three-dimensional (3D) stacking approach by vertically stacking multiple HBM dynamic random access memory (DRAM) dies 110 on a logic die (also called base die) 108. Each of the HBM DRAM dies 110 is electrically connected to the logic die 108 through through-silicon vias (TSVs) 112. The logic die 108 is a fundamental, non-memory layer at the bottom of the 3D memory stack, and provides an interface with the compute die (e.g., GPU/CPU/SoC die) 102. Specifically, the logic die 108 has an HBM PHY circuit (labeled by "PHY") 114 that is electrically connected to an HBM PHY circuit (labeled by "PHY") 116 on the compute die 102. The HBM PHY circuit 114/116 includes a plurality of physical channels each split into multiple pseudo channels. For example, regarding one 3D memory stack of the HBM 104, one 64-bit physical channel may be split into two 32-bit pseudo channels. In this embodiment, both of the HBM PHY circuits 114 and 116 support channel redundancy. Specifically, each of the HBM PHY circuits 114 and 116 supports one or more redundant HBM channels (e.g., redundant physical channel(s) or redundant pseudo channel(s)). Hence, when one HBM channel (e.g., physical channel or pseudo channel) fails to work normally, a redundant HBM channel (e.g., redundant physical channel or redundant pseudo channel) can be selected to serve as a replacement of the defective HBM channel (e.g., physical channel or pseudo channel), and an HBM controller circuit (labeled by "MC") 118 can control access (read/write) of the HBM 104 through the redundant HBM channel (e.g., redundant physical channel or redundant pseudo channel).

It should be noted that the package structure shown in FIG. 1 is for illustrative purposes only, and is not meant to be a limitation of the present invention. In practice, the present invention has no limitations on the packaging technology used for assembling and encapsulating the compute die 102 and the HBM 104. Furthermore, the number of compute dies and the number of HBMs may be adjusted depending upon actual application considerations. In some embodiments of the present invention, the semiconductor package 100 may be an ASIC chip having more than one compute die 102 and/or more than one HBM 104. These alternative designs all fall within the scope of the present invention.

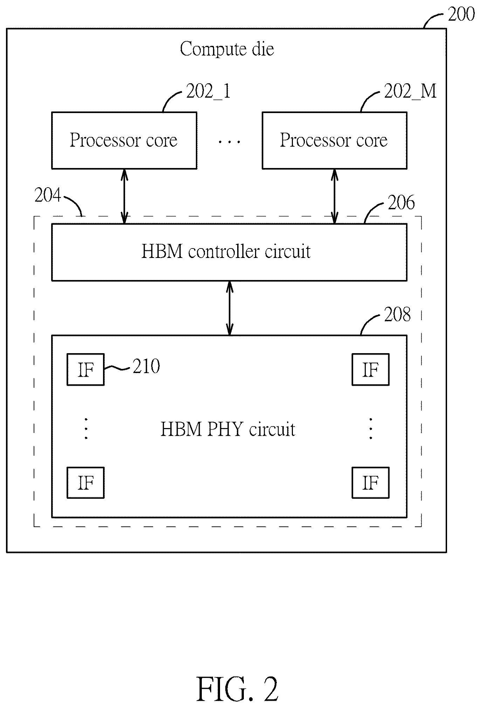

FIG. 2 is a block diagram of a compute die with HBM channel failure tolerance according to an embodiment of the present invention. The compute die 102 shown in FIG. 1 may be implemented using the compute die 200 shown in FIG. 2. In this embodiment, the compute die 200 may be an XPU die including processor core(s) 202_1-202_M (M ≥ 1), an HBM interface subsystem 204, and other circuitry (not shown). The HBM interface subsystem 204 includes an HBM controller circuit 206 and an HBM PHY circuit 208. The HBM controller circuit 206 is configured to control access (read/write) of HBM(s). The HBM PHY circuit 208 is configured to communicate with HBM(s). For example, the compute die 200 and the HBM(s) are placed side-by-side on an interposer. The HBM PHY circuit 208 includes one or more HBM interfaces (labeled by "IF") 210, each being a PHY interface between one HBM and the compute die 200. The difference between a conventional compute die and the proposed compute die 200 is that the HBM interface subsystem 208 of the proposed compute die 200 is configured to tolerate failure of at least one HBM channel through channel redundancy. For example, the HBM interface subsystem 208 of the compute die 200 is capable of tolerating failure of only a single HBM channel (e.g., 1 physical channel or 1 pseudo channel). In a case where 1 pseudo channel failure in the HBM interface subsystem 208 is tolerable on the compute die 200, 1.6x improvement in yield can be achieved. For another example, the HBM interface subsystem 208 of the compute die 200 is capable of tolerating failure of multiple HBM channels (e.g., 2 physical channels or 2 pseudo channels). In a case where 2 pseudo channel failure in the HBM interface subsystem 208 are tolerable on the compute die 200, 1.8x improvement in yield can be achieved.

In some embodiments of the present invention, the number of defective HBM channels (e.g., physical channels or pseudo channels) tolerable on the compute die 200 may depend on an area contribution of the HBM interface subsystem 204 to the compute die 200. For example, the HBM interface subsystem 208 of the compute die 200 is designed to tolerate failure of only a single HBM channel (e.g., 1 physical channel or 1 pseudo channel) under a condition that the HBM interface subsystem 204 occupies X% of a die area of the compute die 200. For another example, the HBM interface subsystem 208 of the compute die 200 is designed to tolerate failure of multiple HBM channels (e.g., 2 physical channels or 2 pseudo channels) under a condition that the HBM interface subsystem 204 occupies Y% of the die area of the compute die 200, where Y > X. However, these are for illustrative purposes only, and are not meant to be limitations of the present invention. In practice, any ASIC chip using the proposed compute die with HBM channel failure tolerance for yield improvement falls within the scope of the present invention.

In some embodiments of the present invention, the HBM interface subsystem 208 of the compute die 200 may be designed to tolerate failure of one HBM channel (e.g., physical channel or pseudo channel) across N HBM interfaces, where N ≥ 1.

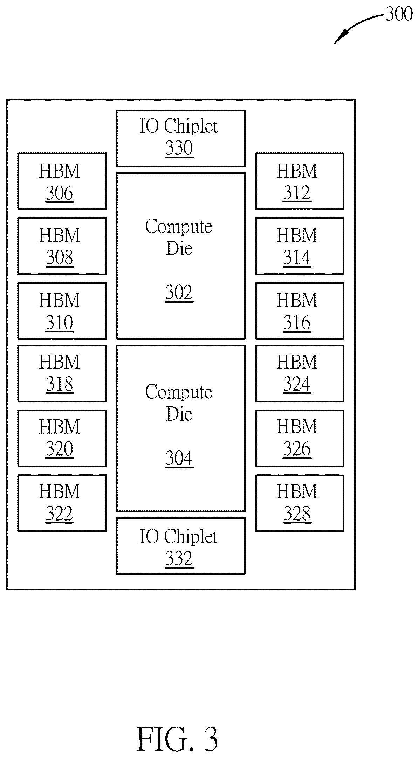

FIG. 3 is a diagram illustrating a first ASIC chip design according to an embodiment of the present invention. The semiconductor package 300 includes multiple compute dies 302, 304, multiple HBMs 306-328, and multiple input/output (IO) chiplets 330, 332. Each of the compute dies 302 and 304 may be implemented using the proposed compute die 200 with HBM channel failure tolerance. Hence, one shoreline of the compute die 302 has HBM interfaces (e.g., HBM interfaces 210 shown in FIG. 2) electrically connected to HBMs 306, 308, 310, respectively, and another shoreline of the compute die 302 has HBM interfaces (e.g., HBM interfaces 210 shown in FIG. 2) electrically connected to HBMs 312, 314, 316, respectively; and one shoreline of the compute die 304 has HBM interfaces (e.g., HBM interfaces 210 shown in FIG. 2) electrically connected to HBMs 318, 320, 322, respectively, and another shoreline of the compute die 304 has HBM interfaces (e.g., HBM interfaces 210 shown in FIG. 2) electrically connected to HBMs 324, 326, 328, respectively. In one exemplary HBM channel failure tolerance design, the compute die 302/304 can tolerate failure of 1 HBM channel (e.g., 1 physical channel or 1 pseudo channel) across 3 HBM interfaces along a shoreline. In another exemplary HBM channel failure tolerance design, the compute die 302/304 can tolerate failure of 1 HBM channel (e.g., 1 physical channel or 1 pseudo channel) in each HBM interface.

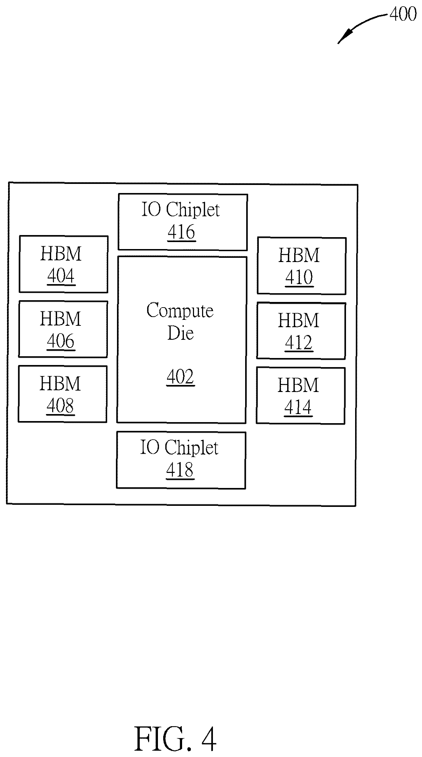

FIG. 4 is a diagram illustrating a second ASIC chip design according to an embodiment of the present invention. The semiconductor package 400 includes a single compute die 402, multiple HBMs 404-414, and multiple IO chiplets 416, 418. The compute die 402 may be implemented using the proposed compute die 200 with HBM channel failure tolerance. Hence, one shoreline of the compute die 402 has HBM interfaces (e.g., HBM interfaces 210 shown in FIG. 2) electrically connected to HBMs 404, 406, 408, respectively, and another shoreline of the compute die 402 has HBM interfaces (e.g., HBM interfaces 210 shown in FIG. 2) electrically connected to HBMs 410, 412, 414, respectively. In one exemplary HBM channel failure tolerance design, the compute die 402 can tolerate failure of 1 HBM channel (e.g., 1 physical channel or 1 pseudo channel) across 3 HBM interfaces along a shoreline. In another exemplary HBM channel failure tolerance design, the compute die 402 can tolerate failure of 1 HBM channel (e.g., 1 physical channel or 1 pseudo channel) in each HBM interface.

When there is failure in K HBM channels (K ≥ 1), the proposed compute die with HBM channel failure tolerance can tolerate failure in K HBM channels (K ≥ 1) by channel redundancy, and can make the overall system work normally. In this way, the yield can be improved dramatically. Specifically, failure of K HBM channels (K ≥ 1) may result from packaging defects. For example, the proposed compute die with HBM channel failure tolerance can resolve HBM & compute die attach yield loss due to HBM PHY area. The yield loss at die attach can be reduces by ~18x. This translates to significant cost savings.

The proposed compute die with HBM channel failure tolerance can tolerate failure in K HBM channels (K ≥ 1) by channel redundancy. In some embodiments of the present invention, failure of K HBM channels (K ≥ 1) may result from runtime failure because of aging and degradation. If there is runtime failure in an HBM channel (e.g., physical channel or pseudo channel), a redundant HBM channel (e.g., redundant physical channel or redundant pseudo channel) can kick in and make the overall system work normally by swapping out a defective HBM channel for the redundant one (which is free of runtime failure).

## Claims

1. A compute die (102, 200, 302, 304, 402) **characterized by**:
a high bandwidth memory, HBM, interface subsystem (204), comprising:
an HBM controller circuit (206), configured to control access of at least one HBM (104, 306, 308, 310, 312, 314, 316, 318, 320, 322, 324, 326, 328, 404, 406, 408, 410, 412, 414); and
an HBM physical layer, PHY, circuit (208), configured to communicate with the at least one HBM (104, 306, 308, 310, 312, 314, 316, 318, 320, 322, 324, 326, 328, 404, 406, 408, 410, 412, 414);
wherein the HBM interface subsystem (204) is configured to tolerate failure of at least one HBM channel through channel redundancy.

2. The compute die (102, 200, 302, 304, 402) of claim 1, **characterized in that** the at least one HBM channel comprises only a single channel.

3. The compute die (102, 200, 302, 304, 402) of claim 2, **characterized in that** the single channel is a pseudo channel.

4. The compute die (102, 200, 302, 304, 402) of claim 1, **characterized in that** the at least one HBM channel comprises multiple channels.

5. The compute die (102, 200, 302, 304, 402) of claim 4, **characterized in that** each of the multiple channels is a pseudo channel.

6. The compute die (102, 200, 302, 304, 402) of claim 1, **characterized in that** the HBM PHY circuit (208) comprises:
a plurality of HBM interfaces (210), configured to communicate with a plurality of HBMs (104, 306, 308, 310, 312, 314, 316, 318, 320, 322, 324, 326, 328, 404, 406, 408, 410, 412, 414), respectively;
wherein the HBM interface subsystem (204) is configured to tolerate failure of one HBM channel in each of the plurality of HBM interfaces (210).

7. The compute die (102, 200, 302, 304, 402) of claim 1, **characterized in that** the HBM PHY circuit (208) comprises:
a plurality of HBM interfaces (210), configured to communicate with a plurality of HBMs (104, 306, 308, 310, 312, 314, 316, 318, 320, 322, 324, 326, 328, 404, 406, 408, 410, 412, 414), respectively;
wherein the HBM interface subsystem (204) is configured to tolerate failure of one HBM channel across multiple HBM interfaces (210) included in the plurality of HBM interfaces (210).

8. The compute die (102, 200, 302, 304, 402) of claim 1, **characterized in that** a number of the at least one HBM channel depends on an area contribution of the HBM interface subsystem (204) to the compute die (200, 302, 304, 402).

9. The compute die (102, 200, 302, 304, 402) of claim 1, **characterized in that** the failure of the at least one HBM channel results from packaging defects.

10. The compute die (102, 200, 302, 304, 402) of claim 1, **characterized in that** the failure of the at least one HBM channel results from runtime failure.

11. A semiconductor package **characterized by**:
at least one high bandwidth memory; and
the compute die of any of claims 1-10.
